# EUROPEAN PATENT APPLICATION

(11) **EP 4 671 683 A2**
(43) Date of publication of application: **31.12.2025**
(21) Application number: 25180112.2
(22) Date of filing: 02.06.2025
(51) Int. Cl.: G01C 19/5783, G01P 1/02, H05K 1/02

(54) **ASSEMBLY METHOD FOR INERTIAL SENSORS IN LIMITED SPACE APPLICATIONS**

(30) Priority: 25.06.2024 US 202418753752
(71) Applicant: Honeywell International Inc., Charlotte, NC 28202 (US)
(72) Inventor: WANG, Fei, Charlotte, 28202 (US); LIU, Yanlin, Charlotte, 28202 (US); YU, Siqin, Charlotte, 28202 (US); LI, Shuang, Charlotte, 28202 (US); LI, Jingwei, Charlotte, 28202 (US)
(74) Representative: Haseltine Lake Kempner LLP

(57) **Abstract**

A sensor assembly comprises a lower housing portion; a sensor board positioned in the lower housing portion, with the sensor board having a bottom surface and a top surface; and one or more inertial sensors connected to the bottom surface of the sensor board. At least one vibration protection structure is coupled between the sensor board and an inner surface of the lower housing portion, and a press structure is positioned over the at least one vibration protection structure and separated from the sensor board. A mother board is positioned in the lower housing portion above and separated from the press structure and the sensor board, with the mother board having a bottom surface and a top surface.

## Description

### BACKGROUND

Industrial-grade inertial sensors such as micro-electro-mechanical systems (MEMS) inertial measurement units (IMUs) need to be designed as standalone modules to ensure optimal performance and consideration for the environment. In addition, the integration of a small-sized IMU with excellent performance is highly desirable.

Because of space limitations, in some cases the volume of an IMU is extremely limited by design requirements. In addition, thermal expansion from electronic components can cause printed circuit board stress, which can negatively impact the sensors of the IMU. Also, in a MEMS IMU, the inertial sensors are sensitive to mechanical vibrations and shocks. Such vibrations and shocks can travel through mechanical covers, connectors, screws, and circuit boards of the IMU, which can then negatively impact the inertial sensors.

Accordingly, there is a need for improved methods of assembling inertial sensor devices such as an IMU for use in limited spaces.

### SUMMARY

A sensor assembly comprises a lower housing portion; a sensor board positioned in the lower housing portion, with the sensor board having a bottom surface and a top surface; and one or more inertial sensors connected to the bottom surface of the sensor board. At least one vibration protection structure is coupled between the sensor board and an inner surface of the lower housing portion; and a press structure is positioned over the at least one vibration protection structure and separated from the sensor board. A mother board is positioned in the lower housing portion above and separated from the press structure and the sensor board, with the mother board having a bottom surface and a top surface.

### BRIEF DESCRIPTION OF THE DRAWINGS

Features of the present invention will become apparent to those skilled in the art from the following description with reference to the drawings. Understanding that the drawings depict only typical embodiments and are not therefore to be considered limiting in scope, the invention will be described with additional specificity and detail through the use of the accompanying drawings, in which:
Figure 1 is a schematic side view of a sensor assembly, according to one embodiment;
Figure 2 is a schematic side view of a sensor board assembly, according to an example embodiment, which can be employed in an inertial sensor assembly such as an inertial measurement unit (IMU); and
Figure 3 is an exploded perspective view of an IMU, according to one embodiment.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

Inertial sensor assemblies and assembly methods for limited space applications, are described herein. Such inertial sensor assemblies are particularly suited for use in constructing an inertial measurement unit (IMU) have a reduced size and low cost, while still maintaining good performance.

In the present approach, separate printed boards are used to form a sensor assembly, including a sensor board for inertial sensors, and a mother board for a microcontroller and other circuits. The sensor board has a connector side and an opposing sensor side. The connector side includes connectors such as a flexible printed circuit (FPC) connector. One or more inertial sensors are coupled to the sensor side of the sensor board.

In one embodiment, the sensor board is a printed circuit board that can use respective stencils of different dimensions on the sensor side and the connector side. For example, on the sensor side a greater stencil thickness can be used (e.g., about 13 µm), and on the connector side a lesser stencil thickness can be used (e.g., about 10 µm). The thicker stencil on the sensor side helps to achieve better performance and anti-vibration stability for the inertial sensor assembly.

In a method of manufacture according to one example, a sensor board is formed by attaching inertial sensors to one side of a printed board (e.g., 2 mm in thickness,) such as by soldering with solder paste using a 13 µm stencil, which increases the solder paste thickness between the inertial sensors and the printed board. The thicker solder paste increases the distance from a connector side of the printed board to the bottom sides of the inertial sensors, which reduces vibration and shock, and protects the bottom sides of the inertial sensors from shape changes of the printed board through different temperatures.

A flexible structure (e.g., silicon material) is wrapped around the sensor board, and a press structure (e.g., steel material) is used to fix the flexible structure and printed board in a bottom housing. This configuration reduces the vibration and shock from the bottom housing to the sensor board. A short length (e.g., about 20 mm) FPC cable is then connected between the sensor board and a separate mother board coupled to the bottom housing. The signals between the sensor board and the mother board are provided by the FPC cable. The FPC cable can have a thickness of about 0.3 mm, which reduces the vibration and shock from the mother board, since the sensor board is isolated from the mother board.

The present inertial sensor devices such as IMUs can be employed in various limited space applications, such as for use in vehicles including uncrewed aerial vehicles, autonomous driving ground vehicles, or the like, as well as in smart antennas or the like.

Further details of various embodiments are described hereafter and with reference to the drawings.

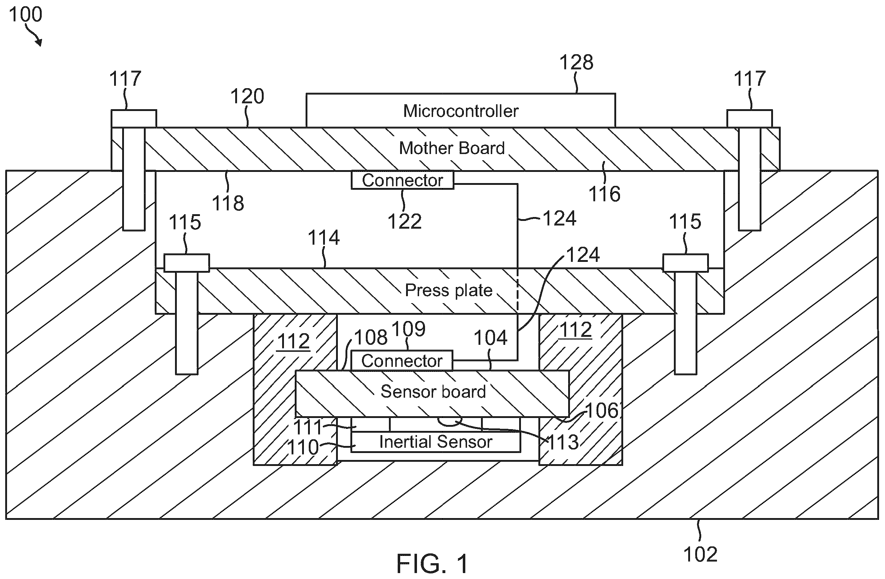

Figure 1 is a schematic side view of a sensor assembly 100, according to one embodiment. The sensor assembly 100 comprises a lower housing portion 102. A sensor board 104 is positioned in lower housing portion 102 and can be a printed circuit board (PCB). The sensor board 104 has a bottom surface 106 and a top surface 108. At least one connector 109, such as a flexible printed circuit (FPC) connector, is coupled to top surface 108 of sensor board 104.

At least one inertial sensor 110 (e.g., MEMS inertial sensor) is connected to bottom surface 106 of sensor board 104, such as with a solder 111. At least one vibration protection structure 112 is coupled between sensor board 104 and an inner surface of lower housing portion 102. A press structure (e.g., plate) 114 is positioned over vibration protection structure 112 and coupled to ledges in lower housing portion 102, such as by a set of screws 115, so as to be separated from sensor board 104 while fixing vibration protection structure 112 and sensor board 104 in lower housing portion 102.

A mother board 116 is coupled to lower housing portion 102, such as by a set of screws 117, such that mother board 116 is above and separated from press structure 114 and sensor board 104. The mother board 116 has a bottom surface 118 and a top surface 120. At least one connector 122, such as a FPC connector, is coupled to bottom surface 118 of mother board 116.

A FPC cable 124 can be connected between top surface 108 of sensor board 104 and bottom surface 118 of mother board 116, such as through respective connectors 109 and 122. Use of the FPC cable connection reduces mechanical impact, such as vibration and shock, from mother board 116 on inertial sensor 110. A microcontroller unit 128 can be coupled to top surface 120 of mother board 116. This position of microcontroller unit 128, spaced apart from sensor board 104, reduces thermal impact on inertial sensor 110.

In various example embodiments of sensor assembly 100, inertial sensor 110 can comprise one or more single-axis or multi-axis inertial sensors. For example, the inertial sensors can include one or more gyroscopes, one or more accelerometers, or combinations thereof. In one embodiment, sensor assembly 100 can be implemented in a MEMS IMU, with multi-axis gyroscopes and multi-axis accelerometers.

In various example embodiments of sensor assembly 100, press structure 114 can be comprised of a steel material, and can have a thickness of at least about 1 mm. For example, a high strength steel press structure having a thickness of about 1 mm, provides for less shape change under high pressure. In addition, vibration protection structure 112 can be comprised of a silicon material. The silicon material provides protection from vibration of housing portion 102, which can negatively affect sensor board 104.

Further, sensor board 104 can be composed of a material having a high glass transition temperature (Tg), such as greater than about 170°C. An example of a suitable material having a high glass transition temperature is EM-370(Z). The high glass transition temperature material for sensor board 104 has improved strength and a better thermal expansion coefficient, which used to improve anti-vibration features and temperature stability for sensor assembly 100. In one example embodiment of sensor assembly 100, sensor board 104 can have a thickness of at least about 2 mm. Such a thickness for sensor board 104 allows inertial sensor 110 to be further removed from connector 109 on the top surface 108, which can cause vibration.

The sensor board 104 can also have a substantially quadrant shape at each of its corners. The quadrant shape at each corner reduces vibration and shock from the corners of sensor board 104.

The inertial sensor 110 can be connected to bottom surface 106 of sensor board 104 such that a distance between inertial sensor 110 and bottom surface 106 is at least about 13 µm. At least one spacer 113 can be attached to bottom surface 106 of sensor board 104. The spacer 113 prevents sensor board 104 from touching inertial sensor 110 during operation, as sensor performance can be highly impacted if sensor board 104 touches inertial sensor 110.

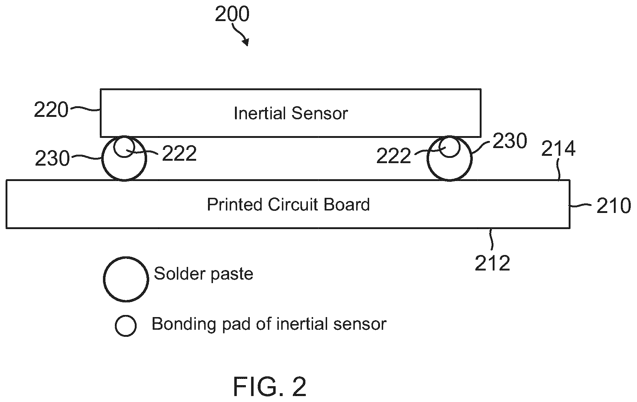

Figure 2 is a schematic side view of a sensor board assembly 200, according to an example embodiment, which can be employed in an inertial sensor assembly such as an IMU. The sensor board assembly 200 includes a printed circuit board 210, which has a connector side 212 and an opposing sensor side 214. At least one inertial sensor 220 (e.g., MEMS inertial sensor) has a set of bonding pads 222 on one side thereof. The inertial sensor 220 is coupled to the sensor side 214 of printed circuit board 210 such as by solder paste 230 applied between bonding pads 222 and sensor side 214.

In one example embodiment, printed circuit board 210 can have a thickness of at least about 2 mm, and can be an be composed of a material having a high glass transition temperature, which provides for better temperature stability. This thickness of printed circuit board 210 can improve any shape change impacts after sensor board assembly 200 is formed, and advantageously provides added distance between connector side 212 of printed circuit board 210 and inertial sensor 220. The material having a high glass transition temperature

In one embodiment, a 13 µm stencil can be used on the sensor side 214, and a 10 µm stencil can be used on connector side 212 during manufacture of sensor board assembly 200. The 13 µm stencil allows for a thicker solder paste than the 10 µm stencil, adding distance between inertial sensor 220 and printed circuit board 210. Larger package components on sensor side 214 allows for use of the 13 um stencil, which increases the solder paste height. In one example embodiment, printed circuit board 210 can have a quadrant shape at each of four corners, which reduces vibration and shock from the corners.

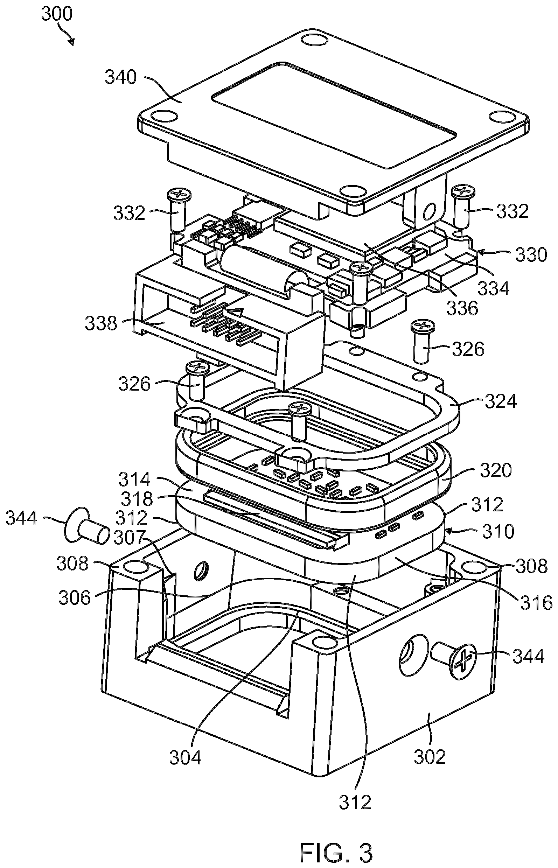

Figure 3 is an exploded perspective view of an inertial measurement unit (IMU) 300 according to one embodiment. The IMU 300 comprises a bottom housing 302, having a lower chamber 304, a middle chamber 306, and an upper chamber 307. A sensor board 310 such as a PCB is configured to be positioned in lower chamber 304. The sensor board 310 has a bottom surface (not shown), a top surface 314, and a perimeter side surface 316. An FPC connector 318 is located on top surface 314 of sensor board 310. A set of inertial sensors (not shown) are coupled to the bottom surface of sensor board 310. The sensor board 310 has quadrant shaped corners 312.

A flexible protection structure 320 is configured to surround perimeter side surface 316 of sensor board 310, such that flexible protection structure 320 is located between sensor board 310 and a surface of lower chamber 304 of bottom housing 302. A press structure 324 is configured to be positioned over flexible protection structure 320 and coupled to a ledge in middle chamber 306 of bottom housing 302, such as by a set of screws 326, so as to be separated from sensor board 310.

A mother board 330 is configured to be positioned in upper chamber 307 so as to be separate from press structure 324 and sensor board 310. The mother board 330 is configured to be coupled to bottom housing 302, such as by a set of screws 332 in upper chamber 307 of bottom housing 302. For optimal performance of IMU 300, screw mounting holes in bottom housing 302 can be placed at a distance greater than about 2 mm from the inertial sensors on sensor board 310.

The mother board 330 has a bottom surface (not shown) and a top surface 334. An FPC connector (not shown) is located on the bottom surface of mother board 330. A microcontroller unit 336 is coupled to top surface 334 of mother board 330. A main connector 338 is coupled to mother board 330 and is operative to provide power, signals, and/or data between mother board 330 and various devices when connected to IMU 300. A top cover 340 is configured to be attached to bottom housing 302 over mother board 330, such as with a set of screws 344 to provide a sealed package for IMU 300.

In one example embodiment, bottom housing 302 can be composed of an aluminum alloy. The press structure 324 can be comprised of a steel material such as stainless steel, and can have a thickness of at least about 1 mm. For example, a 1 mm thick steel press structure provides for less shape change under high pressure, and reduces a total height of IMU 300. For the same thickness, steel has less shape change under high pressure than other materials.

The flexible protection structure 320 can be composed of a silicon material. The silicon material provides a good modulus of elasticity, has an acceptable lifetime, and provides substantial sensor protection from vibration, shock, or stress experienced by IMU 300. The silicon material also easily fills the gaps between sensor board 310 and bottom housing 302.

In addition, sensor board 310 can be composed of a material having a high glass transition temperature. In one example embodiment, sensor board 310 can have a thickness of at least about 2 mm. A 2 mm thickness for sensor board 310 can provide for less shape change impacts after assembly of IMU 300. The FPC connector 318 can have a thickness of at least about 1 mm, which helps in achieving a small height dimension for sensor board 310.

The sensor board 310 is separate from other electrical components of IMU 300. The sensor board 310 is located away from main connector 338 and any related electrostatic discharge (ESD) impacts. The sensors are located away from microcontroller unit 336 to reduce thermal impact on the sensors.

### Example Embodiments

Example 1 includes a sensor assembly comprising a lower housing portion; a sensor board positioned in the lower housing portion, the sensor board having a bottom surface and a top surface; one or more inertial sensors connected to the bottom surface of the sensor board; at least one vibration protection structure coupled between the sensor board and an inner surface of the lower housing portion; a press structure positioned over the at least one vibration protection structure and separated from the sensor board; and a mother board positioned in the lower housing portion above and separated from the press structure and the sensor board, the mother board having a bottom surface and a top surface.

Example 2 includes the sensor assembly of Example 1, wherein the sensor board is comprised of a material having a high glass transition temperature, and has a thickness of at least about 2 mm.

Example 3 includes the sensor assembly of any of Examples 1-2, wherein the sensor board comprises a printed circuit board, and has a quadrant shape at each corner of the sensor board.

Example 4 includes the sensor assembly of any of Examples 1-3, wherein the one or more inertial sensors are connected to the bottom surface of the sensor board such that a distance between the one or more inertial sensors and the bottom surface is at least about 13 µm.

Example 5 includes the sensor assembly of any of Examples 1-4, wherein the one or more inertial sensors comprise one or more gyroscopes, one or more accelerometers, or combinations thereof.

Example 6 includes the sensor assembly of any of Examples 1-5, wherein the press structure is comprised of a steel material, and has a thickness of at least about 1 mm.

Example 7 includes the sensor assembly of any of Examples 1-6, further comprising: a flexible printed circuit cable connected between the bottom surface of the mother board and the top surface of the sensor board; and a microcontroller unit connected to the top surface of the mother board.

Example 8 includes the sensor assembly of any of Examples 1-7, wherein the at least one vibration protection structure is comprised of a silicon material.

Example 9 includes the sensor assembly of any of Examples 1-8, wherein the sensor assembly is implemented in an inertial measurement unit (IMU).

Example 10 includes the sensor assembly of any of Examples 1-9, further comprising at least one spacer attached to the bottom surface of the sensor board, the at least one spacer configured to prevent the sensor board from touching the one or more inertial sensors.

Example 11 includes an inertial measurement unit, comprising a bottom housing having a lower chamber, a middle chamber, and an upper chamber; a sensor board positioned in the lower chamber, the sensor board having a bottom surface and a top surface; a set of inertial sensors connected to the bottom surface of the sensor board; a flexible protection structure surrounding a perimeter of the sensor board such that the flexible protection structure is located between the sensor board and a surface of the lower chamber; a press structure positioned over the flexible protection structure and separated from the sensor board, the press structure coupled to a ledge in the middle chamber; a mother board positioned in the upper chamber and separated from the press structure, the mother board having a bottom surface and a top surface, the mother board coupled to the bottom housing; a flexible printed circuit cable connected between the bottom surface of the mother board and the top surface of the sensor board; a microcontroller unit connected to the top surface of the mother board; and a top cover attached to the bottom housing to provide a sealed package for the inertial measurement unit.

Example 12 includes the inertial measurement unit of Example 11, wherein the sensor board is comprised of a material having a high glass transition temperature, and has a thickness of at least about 2 mm.

Example 13 includes the inertial measurement unit of any of Examples 11-12, wherein the sensor board comprises a printed circuit board, and has a quadrant shape at each corner of the sensor board.

Example 14 includes the inertial measurement unit of any of Examples 11-13, wherein the inertial sensors are connected to the bottom surface of the sensor board such that a distance between the inertial sensors and the bottom surface is at least about 13 µm.

Example 15 includes the inertial measurement unit of any of Examples 11-14, wherein the inertial sensors comprise one or more gyroscopes, one or more accelerometers, or combinations thereof.

Example 16 includes the inertial measurement unit of any of Examples 11-15, wherein the inertial sensors comprise micro-electro-mechanical systems (MEMS) inertial sensors, including multi-axis gyroscopes and multi-axis accelerometers.

Example 17 includes the inertial measurement unit of any of Examples 11-16, wherein the press structure is comprised of stainless steel, and has a thickness of at least about 1 mm.

Example 18 includes the inertial measurement unit of any of Examples 11-17, wherein the flexible protection structure is comprised of a silicon material.

Example 19 includes the inertial measurement unit of any of Examples 11-18, wherein the flexible protection structure is configured to substantially protect the sensor board from vibration, shock, or stress experienced by the inertial measurement unit.

Example 20 includes the inertial measurement unit of any of Examples 11-19, further comprising a main connector coupled to the mother board and operative to provide power, signals, or data to/from the mother board.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. A sensor assembly comprising:
a lower housing portion;
a sensor board positioned in the lower housing portion, the sensor board having a bottom surface and a top surface;
one or more inertial sensors connected to the bottom surface of the sensor board;
at least one vibration protection structure coupled between the sensor board and an inner surface of the lower housing portion;
a press structure positioned over the at least one vibration protection structure and separated from the sensor board; and
a mother board positioned in the lower housing portion above and separated from the press structure and the sensor board, the mother board having a bottom surface and a top surface.

2. The sensor assembly of claim 1, wherein the sensor board is comprised of a material having a high glass transition temperature, and has a thickness of at least about 2 mm.

3. The sensor assembly of claim 1, wherein the sensor board comprises a printed circuit board, and has a quadrant shape at each corner of the sensor board.

4. The sensor assembly of claim 1, wherein the one or more inertial sensors are connected to the bottom surface of the sensor board such that a distance between the one or more inertial sensors and the bottom surface is at least about 13 µm.

5. The sensor assembly of claim 1, wherein the one or more inertial sensors comprise one or more gyroscopes, one or more accelerometers, or combinations thereof.

6. The sensor assembly of claim 1, wherein the press structure is comprised of a steel material, and has a thickness of at least about 1 mm.

7. The sensor assembly of claim 1, further comprising:
a flexible printed circuit cable connected between the bottom surface of the mother board and the top surface of the sensor board; and
a microcontroller unit connected to the top surface of the mother board.

8. An inertial measurement unit, comprising:
a bottom housing having a lower chamber, a middle chamber, and an upper chamber;
a sensor board positioned in the lower chamber, the sensor board having a bottom surface and a top surface;
a set of inertial sensors connected to the bottom surface of the sensor board;
a flexible protection structure surrounding a perimeter of the sensor board such that the flexible protection structure is located between the sensor board and a surface of the lower chamber;
a press structure positioned over the flexible protection structure and separated from the sensor board, the press structure coupled to a ledge in the middle chamber;
a mother board positioned in the upper chamber and separated from the press structure, the mother board having a bottom surface and a top surface, the mother board coupled to the bottom housing;
a flexible printed circuit cable connected between the bottom surface of the mother board and the top surface of the sensor board;
a microcontroller unit connected to the top surface of the mother board; and
a top cover attached to the bottom housing to provide a sealed package for the inertial measurement unit.

9. The inertial measurement unit of claim 8, wherein the inertial sensors comprise micro-electro-mechanical systems (MEMS) inertial sensors, including multi-axis gyroscopes and multi-axis accelerometers.

10. The inertial measurement unit of claim 8, wherein the flexible protection structure is configured to substantially protect the sensor board from vibration, shock, or stress experienced by the inertial measurement unit.
